# FASCICULE DE BREVET EUROPEEN

(11) **EP 0 913 075 B1**
(45) Date de publication et mention de la délivrance du brevet: **21.05.2003**
(21) Numéro de dépôt: 97932863.0
(22) Date de dépôt: 09.07.1997
(51) Int. Cl.: H05K 1/03, H02M 7/10, H05G 1/20

(54) **ENSEMBLE REDRESSEUR POUR DISPOSITIF A HAUTE TENSION**
GLEICHRICHTERANORDNUNG FÜR HOCHSPANNUNGSGERÄT
RECTIFIER SET FOR HIGH VOLTAGE DEVICE

(30) Priorité: 16.07.1996 FR 9608860
(43) Date de publication de la demande: 06.05.1999
(73) Titulaire: GE MEDICAL SYSTEMS SA, 78533 Buc Cedex (FR)
(72) Inventeur: JEDLITSCHKA, Hans, F-92320 Châtillon (FR)
(74) Mandataire: Goode, Ian Roy
(86) Numéro de dépôt international: FR9701240
(87) Numéro de publication internationale: WO98003046

(56) Documents cités:
- DE-A- 1 564 780
- US-A- 4 241 360
- US-A- 4 527 229
- US-A- 5 272 612

## Description

La présente invention concerne d'une manière générale l'utilisation de supports en céramique comme support et radiateur thermique pour des ensembles redresseurs à haute tension dans un liquide de refroidissement et d'isolement, et plus particulièrement pour des ensembles redresseurs reliés au secondaire d'un transformateur haute tension pour l'alimentation de tubes à rayons X.

Dans un tube à rayons X, l'anode du tube est amenée à un potentiel pouvant atteindre 150 kV ou plus.

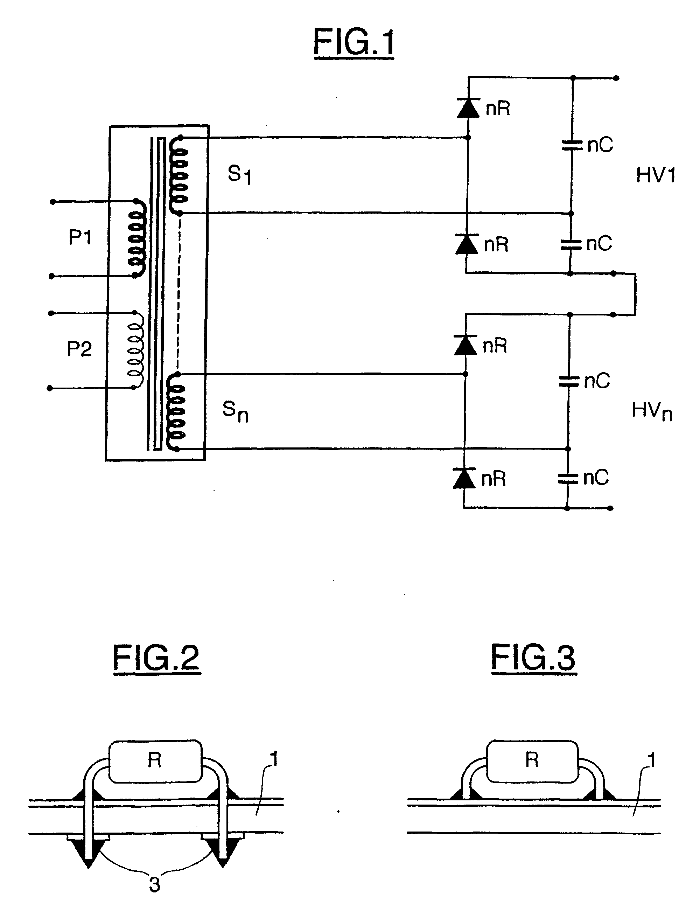

Ces potentiels élevés sont fournis par des dispositifs haute tension, généralement un transformateur dont le secondaire est relié à un circuit de redresseurs R et de condensateurs de filtrage C, également souvent dénommé circuit doubleur de tension. Un tel circuit doubleur de tension est représenté à la figure 1.

Plus précisément, en se référant à cette figure 1, le transformateur comprend plusieurs enroulements primaires, par exemple deux enroulements primaires P1, P2 comme représentés, auxquels sont appliqués des tensions alternatives, et plusieurs enroulements secondaires S1...Sn qui sont reliés à des circuits redresseurs. Classiquement, on utilise des circuits doubleurs de tension. Un circuit doubleur de tension généralement comporte n enroulements secondaires, chaque enroulement secondaire étant relié, par exemple, à 2 diodes de redressement et 2 condensateurs de filtrage de la manière représentée sur la figure 1.

Le circuit de redresseurs doubleurs de tension de chaque enroulement secondaire est relié aux autres de manière que leurs tensions de sortie s'ajoutent, en respectant la polarité des redresseurs, pour obtenir la haute tension voulue pour le tube à rayons X.

Ces circuits redresseurs ou doubleurs de tension sont bien connus dans la technique et il n'est pas nécessaire pour la compréhension de la présente invention, de les décrire plus en détails.

De manière classique, ces circuits de redresseurs haute tension sont montés en série sur une plaquette de circuit imprimé en résine époxy renforcée par des fibres de verre. Cette plaquette et les éléments qu'elle supporte sont disposés dans l'espace haute tension de l'enceinte du dispositif haute tension généralement rempli d'un liquide de refroidissement et d'isolation tel qu'une huile notamment minérale.

Il est de plus en plus fréquent de faire fonctionner les tubes à rayons X en mode pulsé avec des fréquences de pulsations de plus en plus élevées, de l'ordre de plusieurs dizaines de kiloherz. Avec ces nouvelles conditions de fonctionnement, les performances des circuits, comme celui représenté à la figure 1, sont non seulement limitées par les pertes de conduction des redresseurs, mais également par les pertes de commutation des redresseurs engendrant un échauffement des jonctions.

L'utilisation de plaquettes en résine époxy renforcée par des fibresde verre comme support de circuits de redresseurs haute tension présente de multiples inconvénients.

Les redresseurs haute tension montés sur de telles plaquettes présentent une impédance thermique statique et dynamique élevée vis-à-vis de l'huile d'isolation du fait de sa surface en contact avec l'huile et de l'impédance thermique élevée de la résine époxy renforcée par des fibres de verre. Ces deux valeurs limitent la dissipation thermique pour une géométrie donnée de dispositif haute tension et par conséquent la puissance de sortie maximale du dispositif.

Les résines époxy renforcées par des fibres de verre ne sont généralement pas qualifiées pour des applications haute tension car elles renferment des matériaux étrangers et des bulles d'air pouvant engendrer des effets couronnes en présence de champs de haute tension et la destruction du dispositif.

Il n'est pas possible d'utiliser avec ces plaquettes en époxy les procédés et machines de soudure automatique classiques de composants tels que des diodes sur des circuits imprimés du fait du profil pointu des perles de soudage qui ainsi constitueraient des sites privilégiés pour l'établissement de décharges couronnes.

On a représenté à la figure 2 un circuit de redresseurs de ce type comprenant comme support une plaquette en résine époxy renforcée par des fibres de verre avec les défauts inhérents à une telle structure.

Comme on le constate sur la figure 2, le support en résine époxy présente des défauts internes 2 tels que des inclusions et des bulles d'air qui nuisent à la continuité diélectrique et qui constituent des sites de décharges couronnes éventuelles dans l'environnement de champ électrique élevé du dispositif. Egalement, le soudage des éléments, tels que la diode R, se traduit par des pointes de soudage 3 qui créent des densités de champ électrique très élevées et constituent des sites de risque important d'effets couronnes pouvant entraîner la destruction de l'ensemble.

Enfin, il n'est pas possible de souder à plat les composants tels que des diodes sur des plaquettes en résine époxy renforcée par des fibres de verre.

Le document DE-A-1 564 780 décrit un élément semi-conducteur destiné à un redresseur haute-tension à courant continu. Il est prévu un corps de support en oxyde de céramique dans lequel sont creusés des évidements longitudinaux pour accueillir des semi-conducteurs.

Il serait donc souhaitable de réaliser des ensembles redresseurs pour dispositifs haute tension, en particulier destinés à l'alimentation de tubes de rayons X, dans lesquels le support des éléments permet une soudure à plat des éléments, assure une bonne isolation électrique et une bonne dissipation de la chaleur dans l'environnement de refroidissement.

Selon l'invention, on atteint les objectifs ci-dessus en réalisant un ensemble redresseur pour un dispositif haute tension, en particulier destiné à l'alimentation d'un tube de rayons X, comprenant un support en céramique sur lequel les éléments de l'ensemble sont soudés à plat.

Les céramiques, en tant que support des éléments d'un ensemble redresseur haute tension, présentent une combinaison de propriétés thermiques et électriques particulièrement avantageuses.

Les supports en céramique peuvent être obtenus avec un degré de pureté beaucoup plus élevé que les plaquettes en résine époxy renforcée par des fibres de verre, ce qui réduit le risque de décharges couronnes. Les éléments de l'ensemble redresseur, tels que les diodes, peuvent être soudés à plat en utilisant des dispositifs et méthodes de soudage automatique en surface, ce qui facilite la fabrication, et du fait de l'élimination de toute pointe de soudure, diminue encore le risque de décharges couronnes. Les supports en céramique ont en outre une impédance thermique 20 à 50 fois inférieure aux supports en résine époxy renforcée par des fibres de verre et les éléments soudés à plat ont un bon contact thermique avec ce support. La chaleur engendrée par les pertes dans les éléments de l'ensemble redresseur est donc plus facilement évacuée par conduction dans le milieu d'isolation et de refroidissement environnant, tel que de l'huile. Du fait de cette meilleure évacuation de la chaleur, les ensembles redresseurs peuvent supporter des puissances plus élevées.

Parmi les matériaux céramique utilisables comme support des ensembles redresseurs haute tension selon l'invention, on peut citer l'alumine (Al₂O₃), le nitrure d'aluminium (AlN), le carbure de silicium (SiC), et la silice (SiO₂).

Le matériau céramique recommandé dans la présente invention est l'alumine.

On a représenté schématiquement à la figure 3 une partie d'un ensemble redresseur selon l'invention. Comme le montre la figure 3, l'ensemble redresseur comporte un support 1 en matériau céramique. Les éléments de l'ensemble, tels que la diode R, sont soudés à plat sur le support en céramique de sorte que l'ensemble ne présente pas de pointes de soudure, éliminant ainsi des sites potentiels de décharges couronnes. Comme indiqué précédemment, l'emploi d'un matériau céramique pour le support améliore grandement les échanges thermiques avec le liquide de refroidissement environnant, ce qui permet un fonctionnement à puissance plus élevée des éléments de l'ensemble redresseur. Egalement, le support en céramique, qui peut être de grande pureté, présente moins de défauts internes tels que des occlusions et des bulles d'air, et possède donc une meilleure continuité d'isolation électrique.

Ainsi, selon l'invention, on réalise un ensemble redresseur, en particulier pour l'alimentation des tubes à rayons X, plus fiable et pouvant fonctionner à des puissances plus élevées.

## Revendications

1. Ensemble redresseur pour dispositif à haute tension, en particulier pour l'alimentation de tubes à rayons X, comprenant un support (1) sur lequel sont soudés les éléments de l'ensemble redresseur, le support étant constitué d'un matériau céramique, **caractérisé en ce que** les éléments sont soudés à plat sur ce support.

2. Ensemble selon la revendication 1, **caractérisé en ce que** le support en céramique est choisi parmi l'alumine, le nitrure d'aluminium, le carbure de silicium et la silice.

3. Ensemble selon la revendication 2, **caractérisé en ce que** le support en céramique est en alumine.

4. Ensemble selon l'une quelconque des revendications 1 à 3, **caractérisé en ce que** l'ensemble redresseur est constitué par un ou plusieurs circuit(s) doubleur(s) de tension.

5. Procédé de soudure d'élément redresseur pour dispositif à haute tension, en particulier pour l'alimentation de tubes à rayons X, sur un support, le support étant constitué d'un matériau céramique, dans lequel lesdits éléments sont soudés à plat sur ce support.

6. Procédé selon la revendication 5 dans lequel les éléments sont soudés automatiquement en surface.

## Patentansprüche

1. Gleichrichteranordnung für Hochspannungsgerät, insbesondere für die Versorgung von Röntgenstrahlungsröhren, mit einem Träger (1), auf welchen die Elemente der Gleichrichteranordnung geschweißt sind, welcher Träger aus einem keramischen Material gebildet ist, **dadurch gekennzeichnet, dass** die Elemente auf diesen Träger flach geschweißt sind.

2. Anordnung nach Anspruch 1, **dadurch gekennzeichnet, dass** der keramische Träger aus Aluminiumoxid, Aluminiumnitrid, Siliziumkarbid und Siliziumdioxid gewählt ist.

3. Anordnung nach Anspruch 2, **dadurch gekennzeichnet, dass** der keramische Träger aus Aluminiumoxid ist.

4. Anordnung nach einem der Ansprüche 1 bis 3, **dadurch gekennzeichnet, dass** die Gleichrichteranordnung aus einem oder mehreren Spannungsdopplerkreisen gebildet ist.

5. Verfahren zum Schweißen eines Gleichrichterelements für ein Hochspannungsgerät, insbesondere zur Versorgung von Röntgenstrahlungsröhren, auf einen Träger, welcher Träger aus einem keramischen Material gebildet ist, bei welchem die Elemente auf diesen Träger flach geschweißt sind.

6. Verfahren nach Anspruch 5, bei welchem die Elemente automatisch auf die Oberfläche geschweißt werden.

## Claims

1. Rectifier unit for a high-voltage device, in particular for the power supply of X-ray tubes, comprising a substrate (1) on which are soldered the components of the rectifier unit, the substrate consisting of a ceramic material, **characterized in that** the components are soldered flat onto this substrate.

2. Unit according to Claim 1, **characterized in that** the ceramic substrate is chosen from alumina, aluminium nitride, silicon carbide and silica.

3. Unit according to Claim 2, **characterized in that** the ceramic substrate is made of alumina.

4. Unit according to any one of Claims 1 to 3, **characterized in that** the rectifier unit consists of one of more voltage doubler circuit(s).

5. Method for soldering a rectifier component for a high-voltage device, in particular for the power supply of X-ray tubes, onto a substrate, the substrate consisting of a ceramic material, in which the said components are soldered flat onto this substrate.

6. Method according to Claim 5 in which the components are soldered automatically at the surface.
